# EUROPEAN PATENT APPLICATION

(11) **EP 4 822 056 A1**
(43) Date of publication of application: **14.10.2026**
(21) Application number: 26170834.1
(22) Date of filing: 07.04.2026
(51) Int. Cl.: C23C 16/458, C23C 16/46, C23C 16/52, C23C 16/455, C30B 25/12, C30B 25/16, G01B 11/00, G01B 11/06, G01K 11/00, H10P 72/76

(54) **APPARATUS FOR SUPPORTING SUBSTRATES IN A REACTION CHAMBER OF A REACTOR AND REACTION CHAMBER COMPRISING THE SAME**

(30) Priority: 10.04.2025 IT 202500007911
(71) Applicant: LPE S.p.A., 20021 Baranzate (MI) (IT)
(72) Inventor: FATUZZO, Claudia Giuseppina, Catania (IT); PRETI, Silvio Roberto Mario, Baranzate (MI) (IT)
(74) Representative: Buzzi, Notaro & Antonielli d'Oulx S.p.A.

(57) **Abstract**

An apparatus for supporting substrates in a reaction chamber of an epitaxial reactor comprising a disc-shaped element having a first face and a second face, said disc-shaped element being adapted to rotate about an axis (z) thereof, and a shaft coaxial to said disc-shaped element, connected or integral to said disc-shaped element and having a first end at said second face; said shaft has at a second end thereof at least one recession whose rotation is adapted to be detected by contactless measurement device.

## Description

### FIELD OF INVENTION

The present invention relates to the field of deposition of semiconductor films on substrates, in particular to an apparatus for measuring and controlling the rotation speed of substrates in the reaction chamber of a reactor during film deposition.

In particular though not exclusively, the present invention relates to the field of epitaxial deposition of silicon carbide in hot wall or cold wall reactors.

### BACKGROUND OF THE DISCLOSURE

Semiconductor films made by epitaxial growth, also known as epilayers, are formed by deposition in the reaction chamber of a reactor. The deposited material may be the same as the substrate or involve different semiconductors with specific desirable qualities. Epitaxial techniques allow to control the crystal structure formed over the substrate and to improve the epilayer surface's features, making them suitable for the manufacturing of complex microprocessors and memory devices.

In order to ensure uniformity of the epilayers deposited within the reaction chamber, both in terms of thickness and doping concentration, the semiconductor substrates are placed on device that rotates during film deposition. It is important that the rotation speed of the substrates is predetermined and constant during the deposition process, to reduce both thickness deviations and inhomogeneity in doping concentration.

The available techniques for measuring and controlling the rotation speed of the support system are influenced by the actuation mechanism of the same.

For instance, substrate support systems may be set in rotation via mechanical means, which allows precise control of their rotating speed.

For example, a motor external to the reaction chamber may transmit a rotary movement to the apparatus via a shaft. In this case the rotation speed of the substrate support apparatus can be controlled with precision.

However, this solution negatively impacts on manufacturing, maintenance, and assembly operations of the reactor, because of the number of interconnected mechanical parts involved and their placement, which increases the overall complexity of the system.

Alternatively, the substrate support system may be set into rotation via a gas flow, typically an inert gas, which lifts and engages with the device to enable its unimpeded rotation within the reaction chamber.

To this effect, the bottom surface of the support system may be provided with a set of grooves that extend and/or spiral out towards its outer edges, as described in WO2007010568, WO2004053188A1, WO2004053189A1, WO2005121417A1.

The grooves provide preferential path flows for the inert gas. As a result, the support system experiences a torque which sets it into rotation.

US2022411961 describes a device and method for measuring and adjusting the angular speed of a support system in a hot-wall reactor, where the system comprises a disc-shaped element that is set in rotation via an argon gas flow. The disc-shaped element is equipped with a shaft extending below the base of the reaction chamber and features a recess whose rotation is adapted to be detected by a pyrometer. This method for measuring the rotation speed has proven accurate and allows to maintain a constant rotation speed with less than 1 rpm variations. However, the presence and placement of the shaft and of the other structural elements described in the cited art may hinder maintenance operations and increases the downtime of the reactor.

In particular, the presence of the recess attached to the shaft prevents the apparatus from being lifted upward, and from being removed from the reaction chamber for maintenance or replacement with the complete disassembly of the same.

It is therefore desirable to provide an apparatus that allows accurate measurement and control of a substrate angular speed inside a reaction chamber of a reactor, without substantially hindering maintenance operations and ensuring uniformity in film deposition.

It is also desirable to provide a reaction chamber and an epitaxial reactor using such apparatus.

### SUMMARY OF THE DISCLOSURE

This summary is provided to introduce a selection of concepts in a simplified form. These concepts are described in further detail in the detailed description of example embodiments of the disclosure below. This summary is not intended to identify key features or essential features of the claimed subject matter, nor is it intended to be used to limit the scope of the claimed subject matter.

It is an object of the present invention to overcome the disadvantages of the prior art.

In particular, it is an object of the present invention to provide, under a first aspect, an apparatus for supporting substrates in a reaction chamber of a reactor, comprising:
- a disc-shaped element having a first face and a second face, said disc-shaped element being adapted to rotate about an axis (z) thereof,
- a shaft coaxial to said disc-shaped element, connected or integral to said disc-shaped element;
- a contactless measurement device adapted to estimate or determine the distance or temperature or pressure in a contact-less fashion;
where the shaft has the first end at the second face, and where the shaft has at the second end thereof at least one recess whose rotation is adapted to be detected by the contactless measurement device; and where the contactless measurement device is directed towards the at least one recess.

In a second aspect, the invention relates to a reaction chamber for an epitaxial reactor comprising the apparatus hereinbefore described.

In a third aspect the invention relates to an epitaxial reactor comprising one or more reaction chambers hereinbefore described.

The main objectives hereinbefore described are achieved through the invention recited in the appended claims, which constitute an integral part of the present description.

It is noted that the use of reference signs in the claims does not limit their scope. The sole purpose of reference signs is to make the claims easier to understand.

### BRIEF DESCRIPTION OF THE FIGURES

The illustrations presented herein are not meant to be actual views of any particular material, structure, or apparatus, but are merely idealized representations that are used to describe embodiments of the disclosure.
FIG. 1 illustrates the apparatus of the invention in accordance with one embodiment.
FIG. 2 illustrates a reaction chamber in the transverse plane (yz) in accordance with one embodiment of the invention.
FIG. 3 illustrates the reaction chamber of FIG. 2 in the longitudinal plane (xy).
FIG. 4 illustrates the reaction chamber of FIG. 2 in the plane (xy) in accordance with one embodiment of the invention.
FIG. 5 provides a simplified sketch of a reaction chamber according to an embodiment of the present invention.
FIG. 6 provides two panels showing simplified sketches of the reaction chamber of FIG. 5.
FIG. 7 illustrates an arrangement of the apparatus in accordance with one embodiment of the invention.

### DETAILED DESCRIPTION OF EXEMPLARY EMBODIMENTS

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below.

Reference will now be made to the Figures wherein like reference numerals identify similar structural features or aspects of the subject disclosure.

It will be appreciated that elements in the figures are illustrated for simplicity and clarity. In particular some elements may have been omitted or may have not necessarily been drawn to scale. For example, the dimensions of some of the elements in the figures may be exaggerated relative to other elements to help improve understanding of illustrated embodiments of the present disclosure.

Under a first aspect, the present invention relates to an apparatus 100 for supporting substrates in a reaction chamber of an epitaxial reactor.

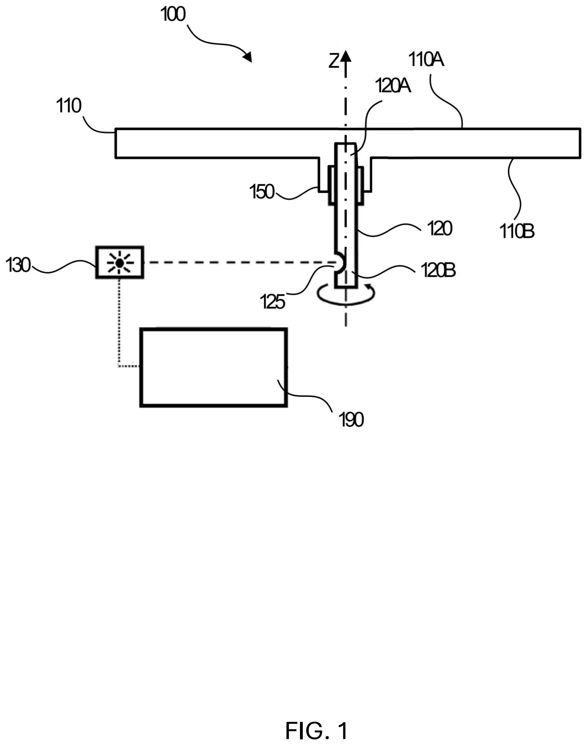

An embodiment of the apparatus 100 is schematically illustrated in FIG. 1.

The apparatus includes the following elements:
- a disc-shaped element 110 having a first face 110A adapted to be upperly positioned when the apparatus 100 is being used, and a second face 110B adapted to be lowerly positioned when the apparatus 100 is being used;
- a shaft 120 coaxial to the disc-shaped element 110, and connected or integral to the disc-shaped element;
- at least one contactless measurement device.

The disc-shaped element 110 is adapted to rotate about an axis (z) thereof.

For example, the disc-shaped element may be adapted to receive a gas flow (F) to rotate the apparatus 100 about the axis (z). To this effect, the second face 110B of the disc-shaped element 110 may feature indentations and/or protrusions designed to impart a torque on the disc-shaped element when exposed to a suitably oriented gas flow.

The shaft comprises a first end 120A and a second end 120B.

The shaft has the first end 120A at the second face 110B.

The second end 120B of the shaft comprises at least one recess 125 whose rotation is adapted to be detected by the contactless measurement device, and the latter is directed towards the at least one recess and is adapted to detect its rotation.

The shaft preferably features an elongated body extending along its rotation axis (z), with two opposite extremities or bases.

Even more preferably, the shaft has an essentially tubular shape, i.e., features a prism-like body with an upper and lower base at its extremities.

Preferably, but not necessarily, the shaft has an essentially circular cross section.

It is noted that the first end 120A and second end 120B of the shaft do not correspond to the bases of the shaft.

The first end 120A and the second end 120B of the shaft refer to opposite, non-overlapping, peripheral regions of the elongated body of the shaft. If the body of the shaft has an overall length "h," the second end 120B may extend from the bottom base of the shaft upwards, preferably not more than 1/2h. On the other hand, the second end may extend from the upper base downwards, preferably not below 1/2h.

With the expression "the shaft has the first end 120A at the second face 110B", it is meant that the region corresponding to the first end faces the second face 110B of the disc-shaped element 110, but it may also further extend above, including across the first face 110A, or slightly below that point.

By contactless measurement device it is meant a device adapted to infer distance, temperature or pressure in contact-less fashion.

Preferably, the contactless measurement device is adapted to infer the distance or the temperature of an object in contact-less fashion, preferably by electromagnetic inspection, including inspection by visible and/or infrared radiation.

Alternatively, the contactless measurement device is adapted to measure pressure variations due to rotation of the shaft, alone or in combination of a suitably directed flow of gas towards the device, through the pressure beats introduced by the rotating recession.

Preferably, when in use, the at least one rotatable recess of the shaft 120 of the apparatus 100 is in a cavity of the reaction chamber, in particular between an inner wall (i.e. a partition element not defining the outer perimeter of the reaction chamber) and an outer wall of the reaction chamber (i.e. a partition element defining at least partially the outer perimeter of the reaction chamber).

By recess it is meant an indentation on the body of the shaft, such as a hole, including a through hole or a blind hole, of any shape.

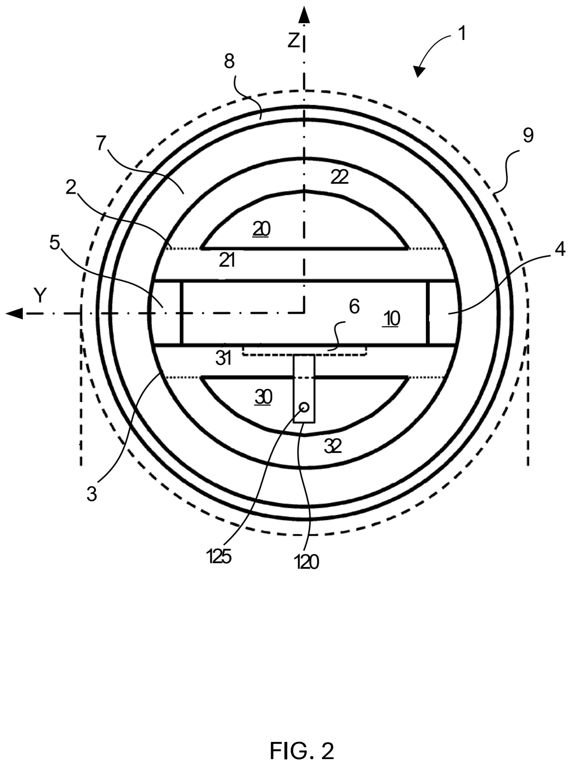

For example, the recess may be a through hole created across the body of the shaft, such as in the embodiment of FIG. 2, or, by generalization, on the sides of the shaft, such as in the embodiment of FIG. 1. In the latter embodiment, the recess is chosen to have a size and shape so that there is at least one angular orientation of the shaft during its rotation about its axis (z) where the recess leaves a clear line of sight through the shaft, which is convenient for use in connection with a contactless temperature measurement device.

Advantageously, the apparatus according to the invention allows to estimate or to determine the rotation speed of a substrate rotating thereon in a reaction chamber of an epitaxial reactor.

To this effect, the contactless measurement device may be kept at a constant direction while the apparatus rotates so that the contactless measurement device alternatively performs the distance or temperature contactless measurement: (a) on the shaft, and (b) on the recess in case it is a nook, or, if the recess is a through hole, on the chamber elements detected through the shaft, such as on the partition element 32.

As a consequence, the temperature or distance measurement performed by the contactless measurement device is subject to a periodic variation due to the apparatus rotation, and in particular to the appearance/disappearance of the recess in the line of sight of the contactless measurement device as the shaft rotates.

The rotation speed may then be calculated based on the period of the periodic variation of the temperature and/or distance signal.

With further advantage, as will become apparent in the following, the apparatus 100 according to the invention can be easily removed from the reaction chamber 1 for PM operations, as it can be lifted upwards and then out of the reaction chamber, without requiring the disassembly of parts. The lifting of the tubular shaft through the partition element 31 where the apparatus 100 is positioned is not hindered by protruding elements, thereby greatly simplifying PM operations.

It is understood that the disc-shaped element may be advantageously adapted to support substrates, directly or via one or more additional elements. These elements may be releasably coupled or in one piece with the disc-shaped element.

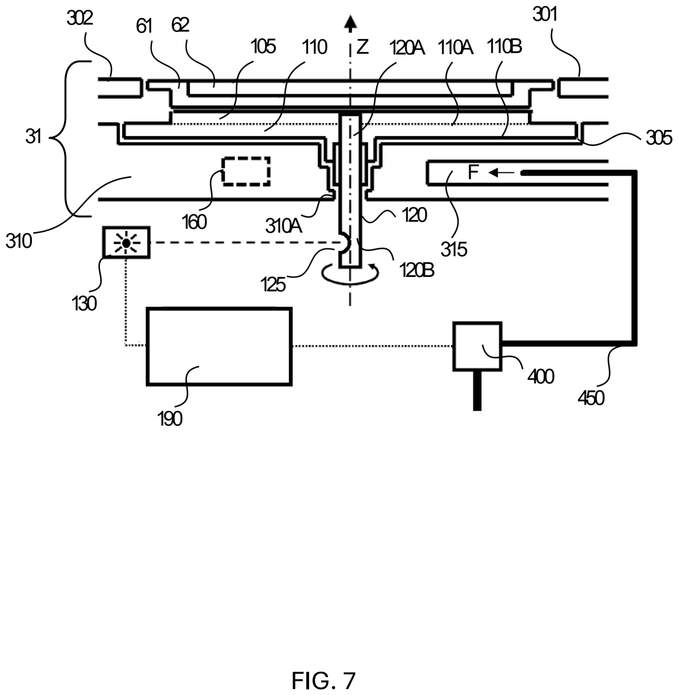

In one embodiment, the apparatus comprises a supporting plate 105 preferably in a single piece with the disc-shaped element 110 and preferably adjacent to its first face 110A (FIG. 7).

The supporting plate 105 and the disc-shaped element 110 thus form a disc-shaped assembly.

The supporting plate 105 may have a discoidal shape having same or different diameter compared to the disc-shaped element 110.

Advantageously, the supporting plate 105 may feature a discoidal shape (such as, for example, a cylinder, plate or saucer) having a smaller diameter than the disc-shaped element 110, to ease interactions with an end effector configured to grab, lift, and/or displace the disc-shaped assembly from a reaction chamber.

In one embodiment, the at least one recess is a through hole, such as a parallel hole extending through the shaft and fully contained therein (FIG. 2).

In one embodiment, the at least one recess extends across a lateral side of the shaft (FIG. 1) and is arranged with respect to the contactless measurement device so that during the rotation of the shaft the latter takes:
(i) at least one position where it is in line of sight with the contactless measurement device, and
(ii) at least one position where it is not in line of sight with the contactless measurement device, and the contactless measurement device is in line of sight with the recess.

It is understood from the above that, in the step of assembling the apparatus in a reaction chamber, the contactless measurement device preferably requires adjusting its direction setting.

Preferably, the at least one recess extends perpendicularly to the axis (z) of the shaft 120.

Advantageously, the above embodiments may be effectively used both in case the contactless measurement device is a contactless distance sensor or a contactless temperature sensor.

In one embodiment, the shaft has two, three, or four recesses at the second end 120B thereof, whose rotation is adapted to be detected by the contactless measurement device.

Preferably, the two, three, or four recesses are equal in size between them.

The two, three, or four recesses may be positioned along the axis (z) of the shaft, or along a direction perpendicular thereof, or any other predetermined position along the shaft.

Advantageously, this may allow independent readings to more precisely determine or estimate the rotation speed of the apparatus 100, without detriment to its ease of extraction from the reaction chamber.

In some embodiments, more than one contactless measurement device may be used to measure the temperature, the distance, or both, in regard to the same or different recesses.

In one embodiment, the shaft 120 is mechanically fixed to the disc-shaped element 110. It is either made in one piece or joined via permanent or releasable means.

In one embodiment, the apparatus 100 comprises a protection socket 150 surrounding the shaft 120 for a portion thereof, with the socket not extending over the at least one recess.

Advantageously, the socket provides a low-friction rotatable guide when the apparatus is placed in the reaction chamber.

In alternative or in addition, a flow of inert gas, such as argon, may be directed towards the rotating parts to lower their friction.

In one embodiment, the contactless measurement device is an optical-thermal device. Preferably the optical-thermal device is a pyrometer 130. Alternatively, though less preferably, the optical-thermal device may be a thermographic camera.

The use of a pyrometer has the advantage of providing a simple periodic temperature signal. The periodicity of the signal may be easily correlated to the rotation speed of the disc-shaped element after calibration.

It must be noted that in case the contactless measurement device is a thermographic camera, signal processing is more complex, but the direction setting of the instrument is less critical.

In one embodiment, the contactless measurement device is a contactless laser triangulation sensor, i.e., a laser distance sensor.

Advantageously, this solution works equally well when the recess is a through hole or a blind cavity or nook in the body of the shaft.

In FIG. 7 the pyrometer is pointing a laser source towards the recess 125 (the laser beam is illustrated as a dashed line). However, it is understood that the pyrometer, the thermographic camera, and/or the laser distance sensor may be optically connected to an optic fiber.

In one embodiment, the apparatus may also include an electronic processing unit 190 electrically connected to the contactless measurement device and adapted to estimate or determine a rotation speed of a substrate-supporting apparatus of the reaction chamber based on the electrical signals received from the contactless measurement device.

Advantageously, this allows to estimate or determine in a convenient fashion the rotation speed of a substrate in the reaction chamber of a reactor, during the deposition process.

Typically, during operation, a substrate 62 is placed on a substrate support element 61, forming an assembly 6. The substrate support element 61 is positioned over the apparatus 100, and more specifically on the disc-shaped element 110 or on the supporting plate 105 of the apparatus if present. Due to gravity, the substrate support element 61 will rotate integrally with the apparatus, and specifically with the disc-shaped element 110 or on the supporting plate 105 of the apparatus if present. While the apparatus may rotate via a mechanical drive, it is preferable to use a flow of inert gas.

For example, the disc-shaped element may be set in rotation via a gas flow (F) of inert gas impinging on its second face 110B, which may be provided with a pattern of grooves and/or protrusions, designed to achieve this effect.

Therefore, the angular velocity of the disc-shaped element corresponds to the rotation speed of the substrate.

In one embodiment, the electronic processing unit is electrically connected to a regulator, such as a Mass Flow Controller 400 (FIG. 7), which is adapted to provide and adjust the gas flow (F) based on the estimated or determined rotation speed of the disc-shaped element.

In this case the regulator is fluidically connected to the duct 315. For instance, in FIG. 7, the tube 450 connects the Mass Flow Controller 400 with the duct 315.

Advantageously, this allows to control, set, and/or correct in real time the rotation speed of the substrate based on the estimated or determined rotation speed of the disc-shaped element, to achieve optimal deposition uniformity and quality.

Preferably, the disc-shaped element 110, supporting plate 105 and the shaft 120 of the apparatus 100 are made of graphite.

In general, as is shown in FIG. 7, the shaft 120 may be integrated with element 110 and element 105. The first end 120A of the shaft 120 may be at both the element 110 and element 105. Furthermore, even if in the example of FIG. 7 the element 110 consists of a circular disc almost perfectly plane and provided with a central hole, it is possible, as an alternative, that instead of the central hole, the element 110 has a central indentation (e.g. a cylindrical indentation) adapted to mechanically couple with the shaft 120; in this case, the first end 120A of the shaft 120 is at the central indentation of the element 110.

The shaft 120 may be mechanically and directly fixed to the disc-shaped element 110; for example, such fixing may be made by a screw, by a tongue-keyway coupling or by snap-fitting.

In a second aspect, the invention relates to a reaction chamber 1 for an epitaxial reactor comprising the apparatus 100 hereinbefore described.

The reaction chamber may include a plurality of partition elements integral or formed as separate parts. These partition elements may form the inner walls and external walls of the reaction chamber. They may comprise planar partition elements (21, 31, 4, 5) and/or curved partition elements (22, 32).

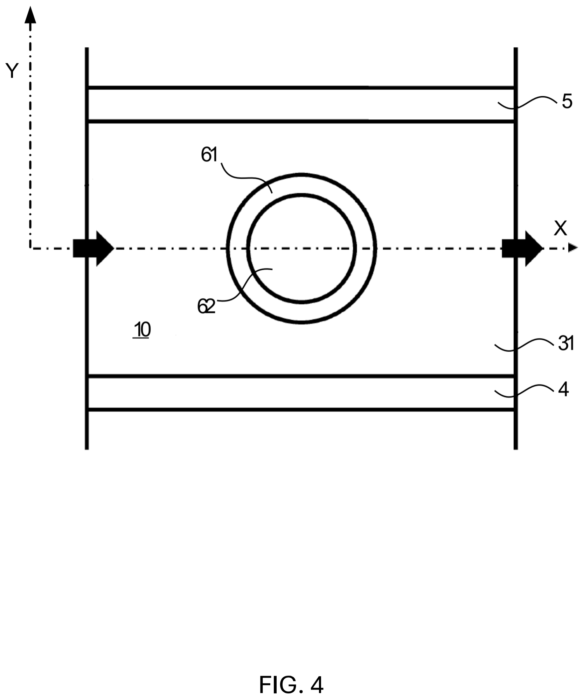

In some embodiments (FIG. 2-FIG. 4) some planar partition elements (21,31) may be in one piece with contacting curved partition elements (22, 32), thereby forming two half-moons.

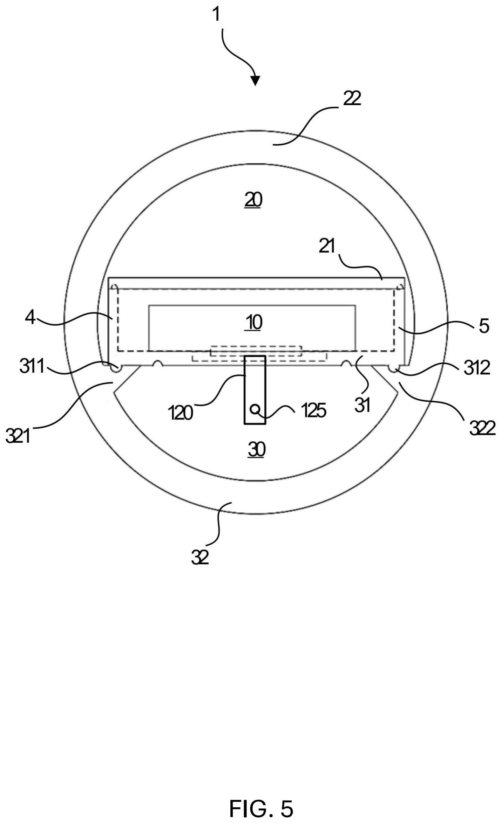

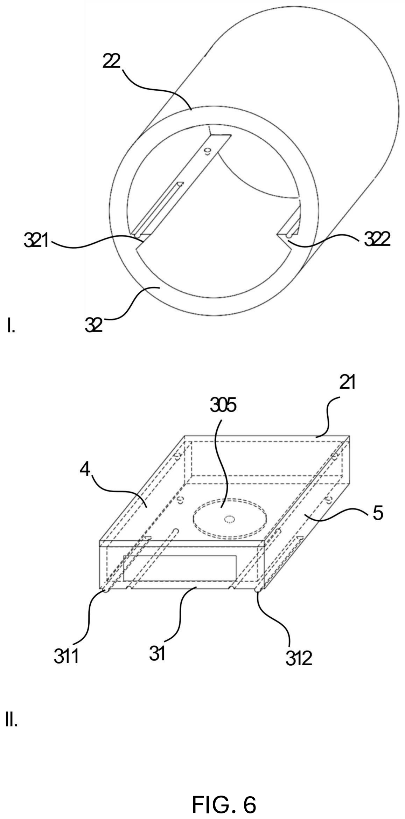

In other embodiments (FIG. 5 and FIG. 6), the planar partition elements (21,31, 4, 5) and the curved partition elements (22, 32) may be respectively integral with each other, thereby forming a cylindrical outer partition enclosure and a box-like inner partition enclosure.

In one embodiment, the reaction chamber includes a gas rotation system for the apparatus 100.

The gas rotation system may comprise one or more inner ducts 315.

The inner ducts 315 may be positioned in the planar partition element 31.

These inner ducts 315, only partially depicted in FIG. 7, are adapted to deliver a "rotation gas" (preferably an inert gas, such as argon) towards the second face 110B of the disc-shaped element 110.

If the latter is provided with suitable grooves, indentations or protrusions, the rotation gas flow sets the disc-shaped element 110 in rotation.

In one embodiment, the reaction chamber includes a plurality of partition elements (21, 22, 31, 32, 4, 5) integral or formed as separate parts, and arranged to form at least two cavities (10, 30).

Preferably the plurality of partition elements forms three cavities (10, 20, 30).

One cavity is a reaction and deposition region 10. It is formed by the partition elements 21, 31, 4, and 5.

The reaction and deposition region 10 is suitable for executing a reaction and deposition process on a rotating substrate 62.

The other cavity is a hollow 30 formed between two contacting or integral partition elements 31 and 32 and is positioned below the reaction and deposition region 10.

In particular, the shaft 120 is positioned so that the at least one recess 125 is placed within the hollow 30 of the reaction chamber 1, between an essentially planar partition element 31 and an essentially curved partition element 32.

In one embodiment, the reaction chamber 1 comprises a seat 305 formed in a partition element 31. The seat 305 is adapted to rotatably house the disc-shaped element 110 of the apparatus 100.

The essentially planar partition element 31 may also comprise one or more coverings or linings 301 and 302, designed to protect the walls of the reaction and deposition region 10 from parasitic deposits. These covering or linings may be periodically removed for cleaning and disposal during PM operations, without detriment to the planar partition element 31 itself.

In a third aspect the invention relates to an epitaxial reactor comprising one or more reaction chambers 1 hereinbefore described.

In the following, preferred ways to carry out the present invention are discussed.

Under an embodiment, the reaction chamber 1 is of the type illustrated schematically in FIG. 2, FIG. 3, and FIG. 4.

The reaction chamber 1 extends uniformly along a longitudinal direction (x). It comprises a chamber assembly including four partition elements 2, 3, 4 and 5, which define a hollow reaction and deposition region 10 and two hollows 20 and 30.

The partition element 2 comprises an essentially planar partition element 21 and an essentially curved partition element 22, integral, attached or in contact with each other.

The partition element 2 comprises an essentially planar partition element 31 and an essentially curved partition element 32, integral, attached or in contact with each other.

The reaction and deposition region 10 is the enclosed area where the reaction and film deposition process takes place.

The reaction chamber 1 also comprises a thermal insulation system 7, surrounding the partition elements.

The thermal insulation system comprises one or more insulating elements made of a heat insulating material.

Porous carbonaceous materials have been proved suitable heat insulating materials.

For instance, carbon composites made from short cut carbon fibers, optionally interconnected in a matrix, or pressed together have been observed to work well in the execution of the invention.

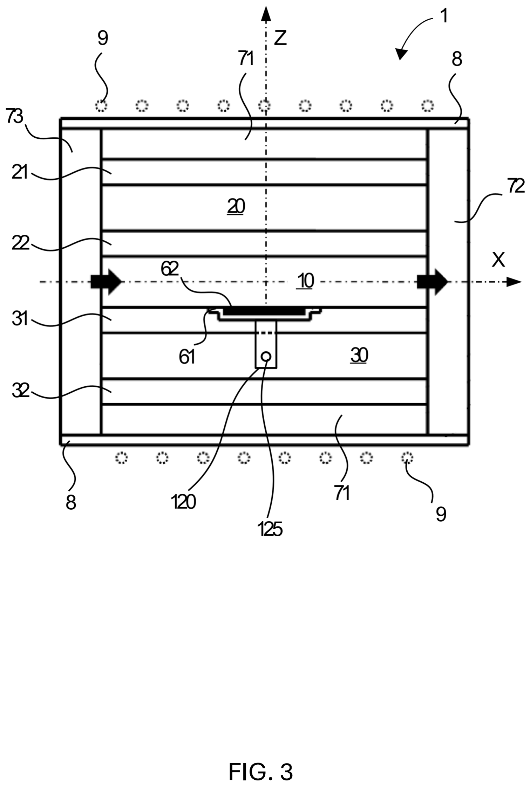

In reference to FIG. 2 and FIG. 3, the thermal insulation system 7 may comprise a tubular casing 71 extending along the longitudinal direction (x) and two caps 72 and 73, oriented parallel to the (yz) plane transverse to the longitudinal direction (x).

The tubular casing 71 and the caps 72 and 73 exhibit an essentially circular-shaped cross section and may be made in single or multiple pieces.

The reaction chamber 1 may also comprise an external enclosure, such as for example a double wall quartz tube 8, optionally adapted to be cooled with a cooling fluid such as water.

The thermal insulation system 7 is inserted within the enclosure 8.

The reaction chamber 1 requires a heating system to reach the required temperatures for the reactor operations.

In case of epitaxial SiC deposition, the heating system will be designed to heat the reaction and deposition region 10 to temperatures of 1400 - 1650 °C.

Under an embodiment, the heating system comprises an inductor 9. The latter may be shaped as a coil and wrapped around the quartz tube 8.

The inductor 9 is represented with a dash line in the figures as it is not strictly part of the reaction chamber 1, but is comprised in the reactor.

The reactor may comprise one or more reaction chambers, such as 1-10, preferably 2-6.

The inductor 9 is adapted to heat by electromagnetic induction one or more partition elements 2, 3, 4 and 5.

To this effect, it is advantageous to have partition elements 2 and 3 made of a susceptive material, such as graphite, optionally coated with silicon carbide or tantalum carbide.

Conversely, the partition elements 4 and 5 may be made of a non-susceptive material, such as polycrystalline silicon carbide.

When the inductor 9 is supplied with an alternating current, alternating electrical currents are induced in the partition elements 2 and 3. This coupling has proven highly effective in providing the appropriate heating temperature and temperature uniformity in the reaction and deposition region 10.

The elements 4 and 5 are two elongated plates, extending along the longitudinal direction, to form the side walls of the reaction and deposition region 10.

The partition elements 2 and 3 are prism-like solids extending along the longitudinal direction and with half-moon section, i.e., the section is in the shape of a circular segment.

The partition elements 2 and 3 respectively comprise a hollow 20 and 30.

The planar partition elements 21 and 31 form the inner upper and lower walls of the reaction and deposition region 10.

The curved partition elements 22 and 32 form the outer walls.

The planar partition element 31 features a seat, i.e., a recess adapted to house an assembly 6.

The assembly 6 comprises a substrate support element 61 adapted to support and rotate at least one substrate 62 subject to deposition.

The substrate support element 61 can be inserted and extracted out of the reaction and deposition region 10. The two caps 72 and 73 feature one or more openings, not shown.

In particular, cap 73 features an opening for the injection of precursor gases, and cap 72 features an opening for discharging exhaust gases. The direction of flow of the precursor gases is exemplified by the black arrow.

Caps 72 or 73 also feature an opening for the insertion of a substrate 62, and/or the assembly 6, and/or the apparatus 100.

The substrate support element 61 may exhibit an indent, such as the step profile illustrated in FIG. 7, to ease engaging with an end effector of a robotic arm adapted to grab, lift and/or displace the substrate support element into and out of the reaction and deposition region.

Typically, the precursor gases entering the reaction chamber 1 may include Si and C precursors. For example, the silicon precursor gas may be a chlorinated compound, preferably dichlorosilane, trichlorosilane or tetrachlorosilane. The carbon precursor gas may be a hydrocarbon, in particular propane, ethylene, acetylene, or methane. Other types of Si and C precursors may be used.

Other precursors, such as for n- and p- doping may flow in the deposition unit of a reactor. For instance, the n-source may be nitrogen, acetonitrile, pyrrole, ammonia, hydrazine, hydrogen cyanide, methylamine.

The caps 72 and 73 may exhibit further openings, optionally protected by windows, to allow the electromagnetic signal of the contactless measurement device to reach the recess inside the hollow 30, in the preferred case when the contactless measurement device is placed outside the thermal insulation system.

Indeed, the contactless measurement device may be advantageously placed outside the hollow 30, even if pointing therein, and even more preferably it is placed outside the thermal insulation system, to prevent its exposure to the high reaction and deposition temperatures.

The planar partition element 31 may also comprise openings for an inner duct 315 adapted to flow an inert gas to rotate the substrate support element 61, via the rotation of the disc-shaped element 110.

In reference to FIG. 7, the planar partition element 31may comprise an upstream covering or lining 301, a downstream covering or lining 302, and a slab 310.

The inner duct 315 may be obtained inside the slab 310 to lead a rotation gas flow (F) to the rear portion of element 110.

The planar partition element 31 may also comprise openings for electric cables adapted to conduct electric signals, for example of a pyrometer 130 and/or of a temperature measuring apparatus 160 placed inside the slab 310 (FIG. 7).

As shown in FIG. 7, the seat of the slab 310 has advantageously an aperture 310A adapted to allow the shaft 120 through the planar partition element 31.

In this fashion, the at least a recess 125 may be positioned inside the hollow portion 30 of the reaction chamber.

The reaction chamber embodiment hereinbefore described and depicted in the referenced figures may be subject to many variations without departing from the scope of the invention.

The reaction chamber may exhibit different cross-sections geometries, and/or an upper partition element 3 with no hollow, and/or having side partition elements 4 and/or 5 with hollows, and/or having a substrate support element adapted to support a plurality of substrates.

For example, in reference to FIG. 5 the reaction chamber 1 may comprise an external partition element comprising the curved partition elements 22 and 32 integral with each other.

This partition element may be made of graphite and can be effectively heated with an inductive heating system, not shown.

In the present embodiment, the reaction chamber 1 further comprises 4 planar partition elements 4, 5, 21, 31, which form a hollow prism-like internal enclosure with rectangular cross section. This internal enclosure defines the reaction and deposition region 10.

When the internal enclosure is placed inside the external enclosure, it can be heated by contact and irradiation from the external enclosure.

In this configuration, it is noted that the planar partition element 21 (31) and the curved partition element 22 (32) form a hollow 20 (30).

The internal enclosure may be equipped with protrusions 311 and 312 on the planar partition element 31. These protrusions may be adapted to engage with corresponding indentations on the protruding guides 321 and 322 of the external enclosure, which may be located on the curved partition element 32.

The apparatus (not shown) can be placed in the seat 305 and extend with the shaft 120, through the partition element 31 inside the hollow 30, with the recess 125 placed within the latter.

FIG. 6 provides further insight on the external and internal partition elements of the reaction chamber embodiment above described. In FIG. 6, the apparatus is not shown for clarity.

The subject matter of the present disclosure includes all novel and nonobvious combinations and subcombinations of the various processes, systems, and configurations, and other features, functions, acts, and/or properties disclosed herein, as well as any and all equivalents thereof.

## Claims

1. An apparatus (100) for supporting substrates in a reaction chamber of a reactor, comprising:
- a disc-shaped element (110) having a first face (110A) and a second face (110B), said disc-shaped element (110) being adapted to rotate about an axis (z) thereof;
- a shaft (120) coaxial to said disc-shaped element (110), connected or integral to said disc-shaped element;
- a contactless measurement device adapted to estimate or determine the distance or temperature or pressure in a contact-less fashion;
wherein said shaft (120) has a first end (120A) at said second face (110B); and
wherein said shaft (120) has at a second end (120B) thereof at least one recess (125) whose rotation is adapted to be detected by the contactless measurement device; wherein the contactless measurement device is directed towards said at least one recess.

2. The apparatus (100) of claim 1, further comprising a supporting plate (105) integral with said disc-shaped element (110) and adjacent to said first face (110A).

3. The apparatus (100) of claim 1 or 2, wherein said at least one recess (125) is a through hole.

4. The apparatus (100) of claim 1 or 2, wherein said at least one recess (125) extends across a lateral side of the shaft (120) and is arranged with respect to the contactless measurement device so that during the rotation of the shaft there is:
- at least one position of the shaft where the shaft is in line of sight with the contactless measurement device;
- at least one position of the shaft where the shaft is not in line of sight with the contactless measurement device.

5. The apparatus (100) of any one of claims 1 to 4, wherein said at least one recess (125) extends perpendicularly to the axis (z) of the shaft.

6. The apparatus (100) of any one of claims 1 to 5, wherein said shaft (120) has two recesses or three recesses or four recesses at the second end (426B) thereof, whose rotation is adapted to be detected by the contactless measurement device, said recesses being preferably equal between them.

7. The apparatus (100) of any one of claims 1 to 6, comprising a protection socket (150) surrounding said shaft (120) for a portion thereof, and wherein said socket does not extend over said at least one recess (125).

8. The apparatus (100) of any one of claims 1 to 7, wherein the contactless measurement device is a pyrometer (130) or a thermographic camera.

9. The apparatus (100) of any one of claims 1 to 7, wherein the contactless measurement device is a contactless laser triangulation sensor.

10. The apparatus (100) of any one of claims 1 to 9, comprising an electronic processing unit (190) electrically connected to the contactless measurement device, and adapted to estimate or determine a rotation speed of the disc-shaped element (110) based on electrical signals received from said contactless measurement device.

11. The apparatus (100) of claim 10, wherein the disc-shaped element (110) is adapted to receive a gas flow (F) to rotate the apparatus (100) about an axis (z) thereof.

12. The apparatus (100) of claim 11, wherein said electronic processing unit (190) is electrically connected to a Mass Flow Controller (400) and is adapted to adjust a rotation gas flow based on said estimated or determined rotation speed of the disc-shaped element (110).

13. A reaction chamber (1) for an epitaxial reactor, comprising an apparatus (100)) according any one of claims 1 to 12.

14. The reaction chamber (1) according claim 13, comprising a gas rotation system for the apparatus (100).

15. The reaction chamber according claims 13 or 14, comprising a plurality of partition elements (21, 22, 31, 32, 4, 5) integral or formed as separate parts and arranged to form at least two cavities, wherein:
- one cavity is a reaction and deposition region (10) formed by the partition elements (21, 31, 4, 5) and suitable for executing a reaction and deposition process on a rotating substrate (62); and
- one cavity is a hollow (30) formed by the partition elements (31, 32) and positioned below the reaction and deposition region (10);
wherein the at least one recess (125) is positioned inside said hollow (30) of the reaction chamber (1), between a planar partition element (31) and a curved partition element (32).

16. The reaction chamber (1) according to any one of claims 13 to 15, further comprising a seat (305) formed in the partition element 31, said seat being adapted to rotatably house the disc-shaped element (110) of the apparatus (100).

17. An epitaxial reactor comprising the reaction chamber (1) according any one of claims 13 to 16.
